# EUROPÄISCHE PATENTANMELDUNG

(11) **EP 3 509 404 A1**
(43) Veröffentlichungstag der Anmeldung: **10.07.2019**
(21) Anmeldenummer: 18150426.7
(22) Anmeldetag: 05.01.2018
(51) Int. Cl.: H05K 3/32, H05K 3/34, H05K 1/09, H05K 1/02

(54) **SCHALTUNGSANORDNUNG SOWIE LEUCHTVORRICHTUNG UND SCHEINWERFER**

(71) Anmelder: ZKW Group GmbH, 3250 Wieselburg (AT)
(72) Erfinder: Kieslinger, Dietmar, 2604 Theresienfeld (AT); Krenn, Günther, 3071 Böheimkirchen (AT); Edlinger, Erik, 1090 Wien (AT); Emmerich, Albrecht, 1150 Wien (AT); Lahner, Markus, 3100 St. Pölten (AT)
(74) Vertreter: Patentanwaltskanzlei Matschnig & Forsthuber OG

(57) **Zusammenfassung**

Die Erfindung betrifft eine Schaltungsanordnung (1) umfassend eine Leiterplatte (2), und zumindest eine an der Leiterplatte (2) befestigte elektronische Komponente (3), wobei die elektronische Komponente (3) als SMD-Bauteil ausgeführt ist und zumindest zwei elektrische Bauteilkontaktflächen (3', 3") aufweist, und die Leiterplatte (2) zumindest zwei zu den Bauteilkontaktflächen (3', 3") korrespondierende Leiterplattenkontaktflächen (2', 2") aufweist, sodass zumindest zwei Kontaktflächenpaare (4', 4") ausgebildet werden, wobei jeweils ein Kontaktflächenpaar (4', 4") durch eine Bauteilkontaktfläche (3', 3") und eine korrespondierende Leiterplattenkontaktfläche (2', 2") ausgebildet wird, wobei ein erstes der zumindest zwei Kontaktflächenpaare (4', 4") eine Lötverbindung (5') aufweist, mit der die Kontaktflächen (2', 3') des ersten Kontaktflächenpaares (4') miteinander verbunden sind, und ein zweites der zumindest zwei Kontaktflächenpaare (4', 4") eine elektrisch leitfähige Klebeverbindung (5") aufweist, mit der die Kontaktflächen (2", 3") des zweiten Kontaktflächenpaares (4") miteinander verbunden sind.

## Beschreibung

Die Erfindung betrifft eine Schaltungsanordnung umfassend eine Leiterplatte, und zumindest eine an der Leiterplatte befestigte elektronische Komponente, wobei die elektronische Komponente als SMD-Bauteil ausgeführt ist und zumindest zwei elektrische Bauteilkontaktflächen aufweist, und die Leiterplatte zumindest zwei zu den Bauteilkontaktflächen korrespondierende Leiterplattenkontaktflächen aufweist, sodass zumindest zwei Kontaktflächenpaare ausgebildet werden, wobei jeweils ein Kontaktflächenpaar durch eine Bauteilkontaktfläche und eine korrespondierende Leiterplattenkontaktfläche ausgebildet wird.

Ferner betrifft die Erfindung eine Leuchtvorrichtung sowie einen Scheinwerfer.

Aus dem Stand der Technik sind Schaltungsanordnungen bekannt geworden, in denen sämtliche elektronische Bauteile entweder mittels Lötverbindungen an einer Leiterplatte befestigt wurden, oder sämtliche Bauteile geklebt wurden. Lötverbindungen und Klebeverbindungen weisen unterschiedliche mechanische, thermische und elektrische Eigenschaften auf, die für die Kontaktierung elektronischer Bauteile mehr oder weniger vorteilhaft sein können. Üblicherweise werden zur Verbindung von elektronischen Bauteilen vermehrt Lötverbindungen vorgesehen. Diese sind dauerhaft und kostengünstig herstellbar. Allerdings haben diese Lötverbindungen bei stark wärmebelasteten elektronischen Bauteilen den Nachteil, dass diese aufgrund ihrer geringen Elastizität gegenüber Wärmedehnung empfindlich sind und deshalb zu Rissbildung neigen können. Die Lebensdauer einer Lötverbindung kann durch Rissbildung stark eingeschränkt sein. Klebeverbindungen hingegen weisen im Allgemeinen eine etwas geringere elektrische und thermische Leitfähigkeit sowie höhere Herstellungskosten auf.

Eine Aufgabe der Erfindung besteht darin, die Verbindung elektronischer Komponenten, die als SMD-Bauteil ausgebildet sind, mit der Leiterplatte zu verbessern.

Diese Aufgabe wird mit einer Schaltungsanordnung der eingangs genannten Art gelöst, indem erfindungsgemäß ein erstes der zumindest zwei Kontaktflächenpaare eine Lötverbindung aufweist, mit der die Kontaktflächen des ersten Kontaktflächenpaares miteinander verbunden sind, und ein zweites der zumindest zwei Kontaktflächenpaare eine elektrisch leitfähige Klebeverbindung aufweist, mit der die Kontaktflächen des zweiten Kontaktflächenpaares miteinander verbunden sind.

Durch Kombination von Klebe- und Lötverbindungen als Verbindungstechnik ist es möglich, dass z.B. jene Kontaktfläche, die thermisch stärker belastet ist, als Lötverbindung ausgebildet ist, wobei eine weitere Kontaktfläche im Gegensatz dazu als Klebeverbindung ausgebildet ist. Klebeverbindungen weisen eine höhere Elastizität auf, sodass Wärmedehnung bis zu einem gewissen Ausmaß möglich ist, ohne die Klebeverbindung oder die Lötverbindung zu schädigen. Genauer gesagt führt die höhere Elastizität der Klebeverbindung zu einer mechanischen Entlastung der Lötverbindung, sodass wärmedehnungsbedingte Rissbildung innerhalb der Lötverbindung verhindert werden kann.

Insbesondere kann vorgesehen sein, dass die elektrisch leitfähige Klebeverbindung durch einen wärmehärtenden Kleber ausgebildet ist. Dadurch ist es möglich, die Härtung der Klebeverbindung mit dem Lötvorgang thermisch zu koppeln.

So kann beispielsweise vorgesehen sein, dass die Härtetemperatur unterhalb der Schmelztemperatur der Lötverbindung liegt und der Kleber im ausgehärteten Zustand zwischenzeitlich zumindest bis zur Schmelztemperatur der Lötverbindung, insbesondere auf eine Temperatur von 250°C, schadlos erwärmbar ist.

Unter dem Ausdruck "schadlos erwärmbar" wird dabei ein Vorgang verstanden, bei dem die mechanischen, thermischen und elektrischen Eigenschaften der Klebeverbindung nach der Aushärtung, die unterhalb einer Temperatur von 250°C erfolgt, trotz einer zwischenzeitlichen Erwärmung auf 250°C unverändert aufrechterhalten bleiben. Die Zeitdauer der zwischenzeitlichen Erwärmung beträgt typischerweise einige Sekunden.

Alternativ zu dem wärmehärtenden Kleber könnte auch eine UV-härtende Klebeverbindung vorgesehen sein.

Des Weiteren kann vorgesehen sein, dass die Lötverbindung durch Lötmaterial und die Klebeverbindung durch ein Klebematerial ausgebildet ist, wobei die Materialien vor der Wärmebehandlung ähnliche mechanische Eigenschaften wie Fließfähigkeit, Viskosität oder Korngröße von Füllstoffen aufweisen bzw. wobei die Materialien vor der Wärmebehandlung jeweils dergestalt hinsichtlich Ihrer Fließfähigkeit, Viskosität und/oder Korngröße von Füllstoffen ausgebildet sind, dass jeweilige Widerstandskraft gegen ein Einsinken einer auf dem jeweiligen Material aufliegenden ebenen Kontaktfläche innerhalb eines Bereichs von +-50%, vorzugsweise +-20%, besonders bevorzugt +-10% des jeweils anderen Materials liegt.

Zudem kann vorgesehen sein, dass zwischen der elektronischen Komponente und der Leiterplatte zumindest ein Abstandshalteelement zum Festlegen des Abstandes zwischen der elektronischen Komponente und der Leiterplatte angeordnet ist. Auf diese Weise kann eine Fehlpositionierung in Normalrichtung zur Leiterplatte verhindert werden, die vor dem Aushärten der Verbindungen anderenfalls z.B. durch Aufschwimmen der elektronischen Komponente oder durch unterschiedliche Viskosität und Einsinken der elektronischen Komponente verursacht werden könnte.

Um sicherzustellen, dass die Klebeverbindung ausreichend hohe elektrische Leitfähigkeit aufweist, kann vorgesehen sein, dass die elektrisch leitfähige Klebeverbindung durch einen elektrisch leitfähigen Kleber mit einem spezifischen elektrischen Widerstand von weniger als 2 mΩ cm ausgebildet ist.

Als Klebstoff zur Herstellung der Klebeverbindung kommen diverse Kleber in Betracht. Grundsätzlich können auch Sinterkleber vorgesehen sein, die beispielsweise Nanopartikel an Metallelementen enthalten, die aufgrund ihrer niedrigen Schmelztemperatur bei für den Lötvorgang erforderlichen Temperaturen schmelzen und damit für eine verbesserte elektrische und thermische Leitfähigkeit der Klebeverbindung sorgen.

Die elektrisch leitfähigen Kleber können prinzipiell alle Klebstoffe umfassen, die durch Silber, Kupfer oder andere Metallpartikel, Graphen, Graphit oder Kohlenstoff elektrische Leitfähigkeit erlangen. Der Begriff "Kleber" umfasst dabei auch Medien, die nanoskopische Metallpartikel bei niedrigen Temperaturen teilweise versintern.

Zudem kann vorgesehen sein, dass die zumindest eine elektronische Komponente eine LED ist.

Insbesondere kann vorgesehen sein, dass die elektronische Komponente eine einer Wärmequelle der elektronischen Komponente thermisch nächstliegende thermische Kontaktfläche aufweist, wobei die Leiterplatte eine dazu korrespondierende thermische Kontaktfläche aufweist, wobei die Kontaktflächen zur Wärmeübertragung von der elektronischen Komponente hin zur Leiterplatte miteinander mittels einer Lötverbindung verbunden sind. Bei der thermischen Kontaktfläche kann es sich um eine zusätzliche zur Wärmeableitung vorgesehene Kontaktfläche oder um eine bestehende elektrische Kontaktfläche handeln.

Vorteilhafterweise kann vorgesehen sein, dass eines der zumindest zwei Kontaktflächenpaare im Betrieb der elektronischen Komponente eine geringere thermische Belastung aufweist, wobei das thermisch geringer belastete Kontaktflächenpaar mittels einer Klebeverbindung elektrisch verbunden ist. Beispielsweise kann bei einer LED, die eine lichtemittierende Fläche aufweist, der der lichtemittierenden Fläche näher liegende Kontakt stärker thermisch belastet sein. Dieser Kontakt kann beispielsweise mit einer Lötverbindung versehen werden, die eine besonders gute Wärmeleitung sicherstellt. Ein verbleibender Kontakt kann wiederum mit einer Klebeverbindung realisiert sein, um Wärmedehnung der LED zu ermöglichen und dennoch eine geeignete elektrische Anbindung zu realisieren.

Die Erfindung betrifft zudem eine Leuchtvorrichtung mit zumindest einer erfindungsgemäßen Schaltungsanordnung.

Weiters betrifft die Erfindung einen Scheinwerfer, insbesondere Kraftfahrzeugscheinwerfer, umfassend eine erfindungsgemäße Schaltungsanordnung und/oder eine erfindungsgemäße Leuchtvorrichtung.

Die Erfindung ist im Folgenden anhand einer beispielhaften und nicht einschränkenden Ausführungsform näher erläutert, die in den Figuren veranschaulicht ist. Darin zeigt

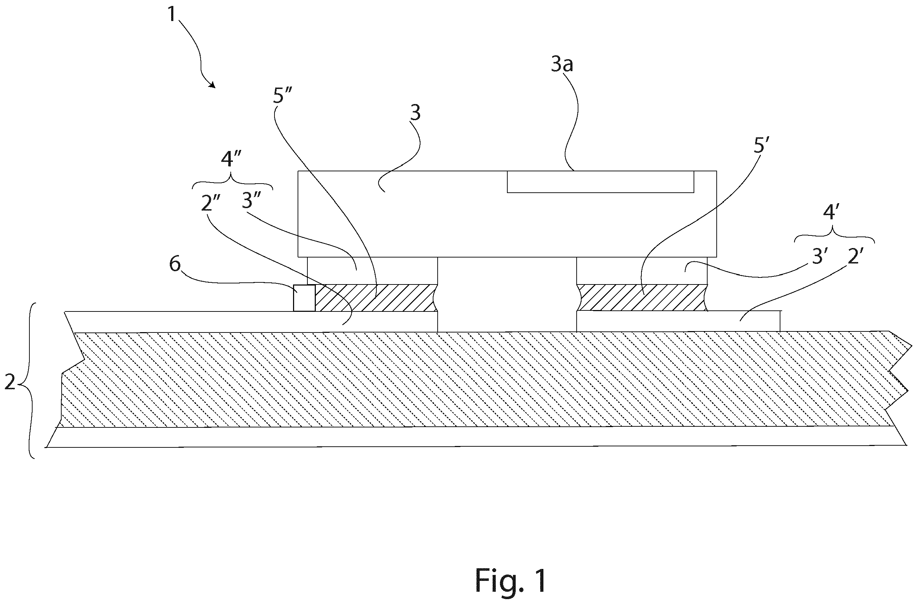

Figur 1 eine schematische Darstellung der Erfindung.

In den folgenden Figuren bezeichnen - sofern nicht anders angegeben - gleiche Bezugszeichen gleiche Merkmale.

Figur 1 zeigt eine Schaltungsanordnung 1 umfassend eine Leiterplatte 2, und zumindest eine an der Leiterplatte 1 befestigte elektronische Komponente 3. Die elektronische Komponente 3 ist im vorliegenden Beispiel als SMD-LED ausgeführt und weist zwei elektrische Bauteilkontaktflächen auf, nämlich eine erste Bauteilkontaktfläche 3' und eine zweite Bauteilkontaktfläche 3". Die Leiterplatte 2 weist zumindest zwei zu den Bauteilkontaktflächen 3' und 3" korrespondierende Leiterplattenkontaktflächen auf, nämlich eine erste Leiterplattenkontaktfläche 2' und eine zweite Leiterplattenkontaktfläche 2". Die erste Bauteilkontaktfläche 3' bildet mit der ersten Leiterplattenkontaktfläche 2' ein erstes Kontaktflächenpaar 4' und die zweite Bauteilkontaktfläche 3" bildet mit der zweiten Leiterplattenkontaktfläche 2" ein zweites Kontaktflächenpaar 4". Die Kontaktflächen 2' und 3' des ersten Kontaktflächenpaares 4' sind mittels einer elektrisch leitenden Lötverbindung 5' miteinander verbunden. Die Kontaktflächen 2" und 3" des zweiten Kontaktflächenpaares 4" sind mittels einer elektrisch leitenden Klebeverbindung 5" miteinander verbunden.

Die Anordnung der Verbindungen 5' und 5" ist dergestalt gewählt, dass jene Kontaktfläche, der eine geringe thermische Belastung zugeordnet ist, als Klebeverbindung ausgebildet ist. im vorliegenden Fall geht die thermische Belastung von einer optisch Wirksamen Fläche 3a der LED aus, die zur Abstrahlung von Licht eingerichtet ist und in der Wärmeverluste anfallen. Diese Wärmeverluste werden einerseits direkt an die Umgebung der LED abgegeben und andererseits über die Lötverbindung 5' sowie Klebeverbindungen 5" in Kontaktflächen 2' und 2" der Leiterplatten eingeleitet, über die die Wärme innerhalb der Leiterplatte verteilt wird. Die Wärmeverteilung innerhalb der Leiterplatte 2 kann entlang von Leiterbahnen und/oder anderen Wärmeleitpfaden innerhalb der Leiterplatte 2 erfolgen.

Im Übrigen sei an dieser Stelle darauf hingewiesen, dass die Lötverbindung geschaffen werden kann, indem Lotpaste auf die Trägerplattenkontaktfläche 2' beispielsweise mittels Schablonendruck oder Stencildruck aufgebracht und dann durch Erwärmen aufgeschmolzen wird. Die Trägerplattenkontaktfläche 2" hingegen kann durch Aufbringen des Klebers, z.b. durch einen Jetdispenser, für die Klebung der Komponente 3 entsprechend vorbreitet werden. Alternativ dazu könnte der Klebe ebenso mittels Schablonendruck aufgebracht werden.

Im vorliegenden Ausführungsbeispiel sind nur zwei Kontaktflächenpaare dargestellt. Alternativ dazu können auch weitere Kontaktflächenpaare vorgesehen sein, die zur elektrischen und/oder thermischen Anbindung der Komponente 3 an die Leiterplatte 2 vorgesehen sein können.

Um ein Einsinken der Komponente 3 in Bezug auf die Leiterplatten 2 zu verhindern, kann vorgesehen sein, dass zwischen der elektronischen Komponente 3 und der Leiterplatte 2 zumindest ein Abstandshalteelement 6 zum Festlegen des Abstandes zwischen der elektronischen Komponente 3 und der Leiterplatte 2 angeordnet ist.

Ferner kann die Schaltungsanordnung 1 als Teil einer in den Figuren nicht dargestellten Leuchtvorrichtung und/oder eines Scheinwerfers ausgebildet sein.

In Anbetracht dieser Lehre ist der Fachmann in der Lage, ohne erfinderisches Zutun zu anderen, nicht gezeigten Ausführungsformen der Erfindung zu gelangen. Die Erfindung ist daher nicht auf die gezeigte Ausführungsform beschränkt. Auch können einzelne Aspekte der Erfindung bzw. der Ausführungsform aufgegriffen und miteinander kombiniert werden. Wesentlich sind die der Erfindung zugrunde liegenden Gedanken, die durch einen Fachmann in Kenntnis dieser Beschreibung in mannigfaltiger Weise ausgeführt werden können und trotzdem als solche aufrechterhalten bleiben. Etwaige Bezugszeichen in den Ansprüchen sind beispielhaft und dienen nur der einfacheren Lesbarkeit der Ansprüche, ohne diese einzuschränken.

## Patentansprüche

1. Schaltungsanordnung (1) umfassend
- eine Leiterplatte (2), und
- zumindest eine an der Leiterplatte (2) befestigte elektronische Komponente (3),
wobei die elektronische Komponente (3) als SMD-Bauteil ausgeführt ist und zumindest zwei elektrische Bauteilkontaktflächen (3', 3") aufweist, und die Leiterplatte (2) zumindest zwei zu den Bauteilkontaktflächen (3', 3") korrespondierende Leiterplattenkontaktflächen (2', 2") aufweist, sodass zumindest zwei Kontaktflächenpaare (4', 4") ausgebildet werden, wobei jeweils ein Kontaktflächenpaar (4', 4") durch eine Bauteilkontaktfläche (3', 3") und eine korrespondierende Leiterplattenkontaktfläche (2', 2") ausgebildet wird, **dadurch gekennzeichnet, dass** ein erstes der zumindest zwei Kontaktflächenpaare (4', 4") eine Lötverbindung (5') aufweist, mit der die Kontaktflächen (2', 3') des ersten Kontaktflächenpaares (4') miteinander verbunden sind, und ein zweites der zumindest zwei Kontaktflächenpaare (4', 4") eine elektrisch leitfähige Klebeverbindung (5") aufweist, mit der die Kontaktflächen (2", 3") des zweiten Kontaktflächenpaares (4") miteinander verbunden sind.

2. Schaltungsanordnung (1) nach Anspruch 1, wobei die elektrisch leitfähige Klebeverbindung (5") durch einen wärmehärtenden Kleber ausgebildet ist.

3. Schaltungsanordnung (1) nach Anspruch 2, wobei die Härtetemperatur unterhalb der Schmelztemperatur der Lötverbindung (5') liegt und der Kleber im ausgehärteten Zustand zwischenzeitlich zumindest bis zur Schmelztemperatur der Lötverbindung (5'), insbesondere auf eine Temperatur von 250°C, schadlos erwärmbar ist.

4. Schaltungsanordnung (1) nach einem der Ansprüche 1 bis 3, wobei die Lötverbindung (5") durch Lötmaterial und die Klebeverbindung (5') durch ein Klebematerial ausgebildet ist, wobei die Materialien vor der Wärmebehandlung jeweils dergestalt hinsichtlich Ihrer Fließfähigkeit, Viskosität und/oder Korngröße von Füllstoffen ausgebildet sind, dass jeweilige Widerstandskraft gegen ein Einsinken einer auf dem jeweiligen Material aufliegenden ebenen Kontaktfläche innerhalb eines Bereichs von +-50%, vorzugsweise +-20%, besonders bevorzugt +-10% des jeweils anderen Materials liegt.
die Materialien im ungehärteten Zustand ähnliche rheologische Eigenschaften aufweisen.

5. Schaltungsanordnung (1) nach einem der vorhergehenden Ansprüche, wobei zwischen der elektronischen Komponente (3) und der Leiterplatte (2) zumindest ein Abstandshalteelement (6) zum Festlegen des Abstandes zwischen der elektronischen Komponente (3) und der Leiterplatte (2) angeordnet ist.

6. Schaltungsanordnung (1) nach einem der vorhergehenden Ansprüche, wobei die elektrisch leitfähige Klebeverbindung (5") durch einen elektrisch leitfähigen Kleber mit einem spezifischen elektrischen Widerstand von weniger als 2 mΩ cm ausgebildet ist.

7. Schaltungsanordnung (1) nach einem der vorhergehenden Ansprüche, wobei die zumindest eine elektronische Komponente (3) eine LED ist.

8. Schaltungsanordnung (1) nach einem der vorhergehenden Ansprüche, wobei die elektronische Komponente (3) eine einer Wärmequelle der elektronischen Komponente (3) thermisch nächstliegende thermische Kontaktfläche aufweist, wobei die Leiterplatte (2) eine dazu korrespondierende thermische Kontaktfläche aufweist, wobei die Kontaktflächen zur Wärmeübertragung von der elektronischen Komponente (3) hin zur Leiterplatte (2) miteinander mittels einer Lötverbindung (5") verbunden sind.

9. Schaltungsanordnung (1) nach einem der vorhergehenden Ansprüche, wobei eines der zumindest zwei Kontaktflächenpaare (4', 4") im Betrieb der elektronischen Komponente (3) eine geringere thermische Belastung aufweist, wobei das thermisch geringer belastete Kontaktflächenpaar mittels einer Klebeverbindung (5') elektrisch verbunden ist.

10. Leuchtvorrichtung mit zumindest einer Schaltungsanordnung (1) nach einem der vorhergehenden Ansprüche.

11. Scheinwerfer, insbesondere Kraftfahrzeugscheinwerfer, umfassend eine Schaltungsanordnung (1) nach einem der Ansprüche 1 bis 9 und/oder eine Leuchtvorrichtung nach Anspruch 10.
